# EUROPÄISCHE PATENTSCHRIFT

(11) **EP 0 895 357 B1**
(45) Veröffentlichungstag und Bekanntmachung des Hinweises auf die Patenterteilung: **01.10.2003**
(21) Anmeldenummer: 98112643.6
(22) Anmeldetag: 08.07.1998
(51) Int. Cl.: H03K 17/082

(54) **Getaktete Leistungsendstufenschaltung zur Steuerung und Regelung induktiver Lasten im PWM-Betrieb**
PWM switching power output stage for controlling and regulating inductive loads
Etage de sortie de puissance à découpage pour la commande et la régulation de charges inductives par modulation de largeur d'impulsions

(30) Priorität: 31.07.1997 DE 19732959
(43) Veröffentlichungstag der Anmeldung: 03.02.1999
(73) Patentinhaber: GKR Gesellschaft für Fahrzeugklimaregelung mbH, D-71701 Schwieberdingen (DE)
(72) Erfinder: Eisenhardt, Harald, 71277 Rutesheim (DE); Falliano, Rolf, 73635 Steinenberg (DE)
(74) Vertreter: Voss, Klaus, Dipl.-Ing.

(56) Entgegenhaltungen:
- EP-A- 0 072 523
- EP-A- 0 599 455
- EP-A- 0 849 753
- US-A- 4 721 869
- US-A- 4 890 185
- US-A- 5 467 242
- BRAUSCHKE P ET AL: "TEMPFET - ONE STEP CLOSER TO AN IDEAL POWER SEMICONDUCTOR SWITCH" SIEMENS COMPONENTS, Bd. 24, Nr. 6, 1.Dezember 1989, Seiten 228-232, XP000095516

## Beschreibung

### Stand der Technik

Die Erfindung betrifft eine getaktete Leistungsendstufenschaltung zur Steuerung und Regelung induktiver Lasten im PWM-Betrieb, bei der ein PWM-Generator in Abhängigkeit von einem externen Sollwert und einem Istwert der Leistungsendstufe ein pulsweitenmoduliertes Ansteuersignal abgibt, wie sie in der nicht vorveröffentlichten EP 0849 753 A2 angegeben ist. Bei dieser bekannten Leistungsendstufenschaltung ist eine Leistungsbegrenzungsschaltung für einen linearen Ansteuerbetrieb ausgelegt, wobei die Ansteuerung aus einem normalen getakteten Betrieb in einen linearen Ansteuerbetrieb übergeht, wenn die Endstufenkennlinie aus dem Arbeitsbereich kommend eine Leistungsbegrenzungskennlinie schneidet.

Andere derartige getaktete Leistungsendstufenschaltungen werden auch zur Ansteuerung von Elektromotoren verwendet und sind bekannt. Ein Nachteil dieser bekannten Leistungsendstufenschaltungen ist der mangelnde Schutz bei Überlast, Kurzschluß oder zu hohen Temperaturen, wodurch nicht nur der Motor, sondern auch die Leistungsendstufe oder andere Schaltelemente beschädigt werden können.

Aus der EP-A-0 599 455 ist eine Schutzschaltung für einen Leistungstransistor bekannt zum Schutz gegen Überströme. Bei einer Überlastsituation wird die Gatespannung reduziert. Eine Serienschaltung eines Widerstands und einer Kapazität beschleunigt die Veränderung der Gatespannung.

Wie z.B. die DE 43 16 185 A1 zeigt, ist schon versucht worden, die Leistungsendstufe dadurch gegen Kurzschluß zu schützen, daß in Abhängigkeit von Spannungsabfall an der Leistungsendstufe das Ansteuersignal zeitweise zu begrenzen. Diese Art von Schutz ist jedoch nicht für alle Fehlerquellen ausreichend.

Es sind auch zählergesteuerte Überstromabschaltungen bekannt, bei denen bei einem vorgegebenen Ausgangsstrom abgeschaltet und die Leistungsendstufe beim Überschreiten der voreingestellten Quelle über eine bestimmte Anzahl von Impulsen oder innerhalb eines festen oder variablen Zeitfensters abgeschaltet wird. Derartige Schutzmaßnahmen sind aber nicht optimal auf die Anforderungen abgestimmt, die sich bei der Ansteuerung von induktiven Lasten stellen.

### Vorteile der Erfindung

Es ist Aufgabe der Erfindung, eine Leistungsendstufenschaltung der eingangs erwähnten Art zu schaffen, bei der auf einfache und eindeutige Art ein optimaler Schutz der Leistungsendstufe und der induktiven Last im Fehler- und Überlastfall erreicht wird.

Diese Aufgabe wird mit den Merkmalen des Anspruchs 1 gelöst.

Im Fehler- oder Überlastfall wird das von der Schutzschaltung abgegebene lineare Ansteuersignal vom getakteten Ansteuersignal entkoppelt zur Umschaltung vom getakteten PWM-Betrieb auf eine lineare Ansteuerung verwendet. In diesem Betriebszustand wird dann die Leistungsendstufe dauernd eingeschaltet und linear geregelt, wobei die Abweichung des Istwertes vom Sollwert für die Ansteuerung maßgebend ist.

Ist nach einer Ausgestaltung vorgesehen, daß die Kapazität des Überkoppelkondensators ein Vielfaches größer ist als die Eingangskapazität der Leistungsendstufe, dann wird durch die Überkopplung der Schaltflanken über den Überkoppelkondensator das Gate der Leistungsendstufe durch eine Quasikonstantstromquelle angesteuert. Die durch den Miller-Effekt entstehende Gatekapazität als Eingangskapazität der Leistungsendstufe wird durch den Konstantstrom geladen, wodurch hochfrequente Schwingungen im Schaltmoment der Leistungsendstufe wirksam verringert werden.

Ein leistungsstarkes Ansteuersignal für die Leistungsendstufe wird nach einer Ausgestaltung dadurch erhalten, daß zwischen dem PWM-Generator und dem Entkopplungsglied eine Treiberschaltung eingeschleift ist.

Ist vorgesehen, daß im Überlast- und Fehlerfall in Abhängigkeit vom lstwert und vom Sollwert auch der PWM-Generator in den linearen Betrieb mit Dauereinschaltung übergeht, dann befindet sich im Fehler- oder Überlastfall die Leistungsendstufenschaltung insgesamt in einem statischen Betriebszustand "dauernd ein".

Die Leistungsendstufenschaltung kann nach einer Weiterbildung so abgewandelt werden, daß der PWM-Generator direkt oder über die Treiberschaltung mehrere, durch individuelle Entkopplungsglieder gegeneinander entkoppelte Leistungsendstufen ansteuert, denen individuelle Schutzschaltungen zugeordnet sind, und daß die Schutzschaltungen für die Leistungsendstufen individuelle lineare Ansteuersignale abgeben. Dabei ist dann vorzugsweise vorgesehen, daß die Ausgänge der Leistungsendstufen parallel geschaltet sind und daß allen Schutzschaltungen die gemeinsame Ausgangsspannung als Istwert zugeführt ist.

Die Leistungsendstufen können z.B. mit FET-Transistoren aufgebaut werden.

Ist nach einer weiteren Ausgestaltung vorgesehen, daß die Gateanschlüsse der Leistungsendstufen als Prüfanschlüsse zugänglich sind, dann können mit entsprechenden Sperrspannungen als Prüfspannung die nicht zu prüfenden Leistungsendstufen individuell gesperrt und die nicht gesperrte Leistungsendstufe in ihrer Funktion individuell überprüft werden.

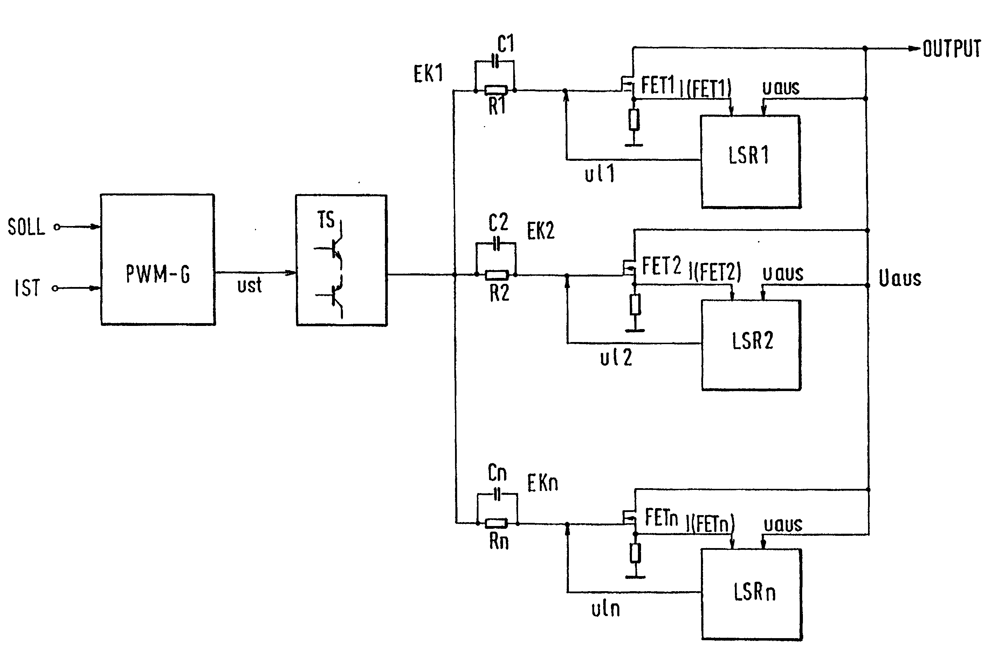

Die Erfindung wird anhand eines in der Zeichnung als Blockschaltbild dargestellten Ausführungsbeispieles näher erläutert.

Der (Pulsweitenmodulations-) PWM-Generator PWM-G wird von einem externen Sollwert SOLL und einem schaltungsindivduellen Istwert IST gesteuert und gibt ein sägeförmiges Ansteuersignal ust für Leistungsendstufen FET1, FET2, FETn ab.

Das Ansteuersignal ust wird über eine Treiberschaltung TS und pro Leistungsendstufe FET1, FET2, FETn über je ein Entkopplungsglied EK1, EK2 und EKn den Gate-Eingängen von FET-Transistoren zugeführt, die als Leistungsendstufen FET1, FET2 und FETn eingesetzt sind. Selbstverständlich ist die Leistungsendstufenschaltung auch nur mit einer einzigen Leistungsendstufe und einem zugeordneten Entkopplungsglied aufbaubar. Dann kann unter Umständen die Treiberschaltung TS entfallen.

Der PWM-Generator PWM-G kann so gesteuert und geregelt sein, daß bei einem Istwert IST, der kleiner ist als der Sollwert SOLL, ein pulsmoduliertes Ansteuersignal ust abgegeben wird, bei dem die Impulsweite umso größer ist je mehr der Istwert IST vom Sollwert SOLL abweicht. Unterschreitet der Istwert IST einen bestimmten Wert, dann kann ein Daueransteuersignal abgegeben werden, mit dem die Leistungsendstufen FET1, FET2 und FETn in den Dauereinschaltzustand gesteuert werden. Überschreitet der lstwert IST den vorgegebenen Sollwert SOLL, dann unterbleibt die Abgabe eines Ansteuersignals USt und die Leistungsendstufen FET1, FET2 und FETn gehen in den Dauerausschaltzustand über.

Die Entkopplungsglieder EK1, EK2 und EKn bestehen jeweils aus einer Parallelschaltung eines für das Ansteuersignal ust im PWM-Betrieb niederohmigen Überkoppelkondensators C1, C2 bzw. C3 und einem hochohmigen Widerstand R1, R2 bzw. R3. Die Kapazität der Überkoppelkondensatoren C1, C2 und C3 beträgt ein Vielfaches von z.B. 10- bis 20-fachem der Eingangskapazität der Leistungsendstufe FET1, FET2 bzw. FETn. Bei dieser Auslegung werden die Schaltflanken des Ansteuersignales ust über den Überkoppelkondensator C1, C2 bzw. Cn dem Gate der Leistungsendstufe FET1, FET2 bzw. FETn durch eine Art Quasikonstantstromquelle zugeführt. Die durch den Miller-Effekt entstehende Gatekapazität wird durch den Konstantstrom geladen, wodurch hochfrequente Schwingungen im Schaltmoment der Leistungsendstufe FET1, FET2 bzw. FETn wirksam verringert werden.

Jeder Leistungsendstufe FET1, FET2 und FETn ist eine Schutzschaltung LSR1, LSR2 und LSRn zugeordnet, der jeweils die gemeinsame Ausgangsspannung Uaus der parallelgeschalteten Leistungsendstufen FET1, FET2 und FETn und der Ausgangsstrom I(FET1), I(FET2) bzw. I(FETn) der zugeordneten Leistungsendstufe FET1, FET2 und FETn zugeführt werden. Im Fehler- und Überlastfall gibt die Schutzschaltung LSR1, LSR2 bzw. LSR3 ein lineares Ansteuersignal ul1, ul2 bzw. uln ab, das direkt auf das Gate der zugeordneten Leistungsendstufe FET1, FET2 bzw. FETn eingekoppelt wird. Die Entkoppelglieder EK1, EK2 und EKn bringen dabei eine Entkopplung des linearen Ansteuersignals ul1, ul2 bzw. uln von dem getakteten Ansteuersignal ust. Die Leistungsendstufen FET1, FET2 und FETn gehen je nach Fehler- und Überlastfall einzeln oder gemeinsam vom getakteten PWM-Betrieb in den linearen Ansteuerbetrieb über, bei dem durchaus der Arbeitspunkt im Leistungsbereich zurückgefahren werden kann. Darüberhinaus kann parallel dazu, bedingt durch eine Änderung des dem PWM-Generator zugeführten lstwert IST, auch der PWM-Generator PWM-G in den linearen Ansteuerbetrieb übergehen kann.

## Patentansprüche

1. Getaktete Leistungsendstufenschaltung zur Steuerung und Regelung induktiver Lasten im PWM-Betrieb, bei der ein PWM-Generator (PWM-G) in Abhängigkeit von einem externen Sollwert (SOLL) und einem Istwert (IST) der Leistungsendstufe ein pulsweitenmoduliertes Ansteuersignal (ust) mit Schaltflanken abgibt, wobei
das Ansteuersignal (ust) der Leistungsendstufe (FET1, FET2, FETn) über ein Entkopplungsglied (EK1, EK2, EKn) mit einer Parallelschaltung aus für das Ansteuersignal (ust) im PWM-Betrieb zum Überkoppeln der Schaltflanken einen niederohmigen Widerstand bildenden Überkoppelkondensator (C1, C2, Cn) und einem dazu hochohmigen Entkopplungswiderstand (R1. R2, Rn) zugeführt ist und wobei mittels einer Schutzschaltung (LSR1, LSR2, LSRn) Ausgangsspannung (Uaus) und/oder Ausgangsstrom l(FET1), l(FET2), l(FET3) der Leistungsendstufe (FET1, FET2, FET3) überwacht ist, die im Überlast- und/oder Fehlerfall ein lineares, dauernd eingeschaltetes Ansteuersignal (Ul1, Ul2, Uln) hinter dem Entkopplungsglied (EK1, EK2, EKn) von dem getakteten Ansteuersignal (ust) entkoppelt einspeist und die Schaltung vom getakteten PWM-Betrieb auf linearen, das dauernd eingeschaltete Ansteuersignal bewirkenden Ansteuerbetrieb umstellt, in welchem auch der PWMT-Generator in Abhängigkeit vom Istwert (IST) und vom Sollwert (SOLL) in den linearen Betrieb mit Dauereinschaltung übergeht und die Leistungsendstufe (FET1, FET2, FETn) dauernd eingeschaltet und mittels der Schutzschaltung (LSR1. LSR2, LSR3) linear geregelt ist.

2. Leistungsendstufenschaltung nach Anspruch 1,
**dadurch gekennzeichnet,**
**daß** die Kapazität des Überkoppelkondensators (C1, C2, Cn) ein Vielfaches (z.B. 10- bis 20-faches) größer ist als die Eingangskapazität der Leistungsendstufe (FET1, FET2, FETn).

3. Leistungsendstufenschaltung nach Anspruch 1 oder 2,
**dadurch gekennzeichnet,**
**daß** zwischen dem PWM-Generator (PWM-G) und dem Entkopplungsglied (EK1, EK2, EKn) eine Treiberschaltung (TS) eingeschleift ist.

4. Leistungsendstufenschaltung nach einem der Ansprüche 1 bis 3
**dadurch gekennzeichnet,**
**daß** der PWM-Generator (PWM-G) direkt oder über die Treiberschaltung (TS) mehrere, durch individuelle Entkopplungsglieder (EK1, EK2, EKn) gegeneinander entkoppelte Leistungsendstufen (FET1, FET2, FETn) ansteuert, denen individuelle Schutzschaltungen (LSR1, LSR2, LSRn) zugeordnet sind, und
**daß** die Schutzschaltungen (LSR1, LSR2, LSRn) für die Leistungsendstufen (FET1, FET2, FETn) individuelle lineare Ansteuersignale (ul1, ul2, uln) abgeben.

5. Leistungsendstufenschaltung nach Anspruch 4,
**dadurch gekennzeichnet,**
**daß** die Ausgänge der Leistungsendstufen (FET1, FET2, FETn) parallel geschaltet sind und
**daß** allen Schutzschaltungen (LSR1, LSR2, LSRn) die gemeinsame Ausgangsspannung (Uaus) als Istwert zugeführt ist.

6. Leistungsendstufenschaltung nach Anspruch 4 oder 5,
**dadurch gekennzeichnet,**
**daß** die Leistungsendstufen (FET1, FET2, FETn) mit FET-Transistoren aufgebaut sind.

7. Leistungsendstufenschaltung nach einem der Ansprüche 4 bis 6,
**dadurch gekennzeichnet,**
**daß** die Gateanschlüsse der Leistungsendstufen (FET1, FET2, FETn) als Prüfanschlüsse zugänglich sind.

## Claims

1. Clocked power output stage circuit for controlling and regulating inductive loads in the PWM operating mode, in which circuit a PWM generator (PWM-G) outputs a pulse-width-modulated actuation signal (ust) with switching edges as a function of an external setpoint value (SETP) and an actual value (ACT) of the power output stage, the actuation signal (ust) of the power output stage (FET1, FET2, FETn) being fed via a decoupling element (EK1, EK2, EKn) to a parallel circuit composed of an overcoupling capacitor (C1, C2, Cn), forming a low-impedance resistor, for the actuation signal (ust) in the PWM operating mode for overcoupling the switching edges, and a decoupling resistor (R1, R2, Rn) which has high impedance with respect to said overcoupling capacitor (C1, C2, Cn), and the output voltage (uout) and/or output current I(FET1), I(FET2), I(FET3) of the power output stage (FET1, FET2, FET3) being monitored by means of a protection circuit (LSR1, LSR2, LSRn), the power output stage (FET1, FET2, FET3) which, in the case of an overload and/or fault, inputs a linear, permanently switched-on actuation signal (Ul1, Ul2, Uln) downstream of the decoupling element (EK1, EK2, EKn), said signal being decoupled from the clocked actuation signal (ust), and said power output stage (FET1, FET2, FETn) switches over the circuit from the clocked PWM operating mode to linear actuation operating mode which brings about the permanently switched-on actuation signal and in which the PWM generator also changes, as a function of the actual value (ACT) and of the setpoint value (SETP), into the linear operating mode with permanent switching-on, the power output stage (FET1, FET2, FETn) is permanently switched on and is regulated linearly by means of the protection circuit (LSR1, LSR2, LSR3).

2. Power output stage circuit according to Claim 1, **characterized in that** the capacitance of the overcoupling capacitor (C1, C2, Cn) is many times (for example 10 to 20 times) greater than the input capacitance of the power output stage (FET1, FET2, FETn).

3. Power output stage circuit according to Claim 1 or 2, **characterized in that** a driver circuit (TS) is looped in between the PWM generator (PWM-G) and the decoupling element (EK1, EK2, EKn).

4. Power output stage circuit according to one of Claims 1 to 3, **characterized in that** the PWM generator (PWM-G) actuates directly, or via the driver circuit (TS), a plurality of power output stages (FET1, FET2, FETn) which are decoupled from one another by means of individual decoupling elements (EK1, EK2, EKn) and which are assigned individual protection circuits (LSR1, LSR2, LSRn),
and **in that** the protection circuits (LSR1, LSR2, LSRn) for the power output stages (FET1, FET2, FETn) output individual linear actuation signals (u11, u12, u1n).

5. Power output stage circuit according to Claim 4, **characterized in that** the outputs of the power output stages (FET1, FET2, FETn) are connected in parallel, and
**in that** the common output voltage (Uout) is fed as actual value to all the protection circuits (LSR1, LSR2, LSRn).

6. Power output stage circuit according to Claim 4 or 5, **characterized in that** the power output stages (FET1, FET2, FETn) are composed of FET transistors.

7. Power output stage circuit according to one of Claims 4 to 6, **characterized in that** the gate terminals of the power output stages (FET1, FET2, FETn) are accessible as test terminals.

## Revendications

1. Etage de sortie de puissance cadencé pour la commande et la régulation de charges inductives en mode à modulation de largeur d'impulsion, dans lequel un générateur à modulation de largeur d'impulsion (PWM-G) fournit en fonction de valeur de consigne externe (SOLL) et d'une valeur réelle (IST) des étages de sortie de puissance, un signal de commande à modulation de largeur d'impulsion (ust) avec des flancs de commutation,
le signal de commande (ust) est fourni à l'étage de sortie de puissance (FET1, FET2, FETn) par un organe de découplage (EK1, EK2, Ekn) ayant un circuit parallèle formé, pour le signal de commande (ust) en mode PWM pour surcoupler les flancs de commutation, d'un condensateur de surcouplage (C1, C2, Cn) formant une résistance faiblement ohmique et d'une résistance de découplage (R1, R2, Rn) fortement ohmique, et
à l'aide d'un circuit de protection (LSR1, LSR2, LSRn), on surveille la tension de sortie (Uaus) et/ou le courant de sortie I(FET1), I(FET2), I(FET3) de l'étage de sortie de puissance (FET1, FET2, FET3), qui, en cas de surcharge et/ou de défaut, fournit derrière l'élément de découplage (EK1, EK2, EKn) un signal de commande (Ul1, Ul2, Uln) linéaire, continu, découplé du signal de commande cadencé (ust), et commute le circuit du mode à modulation de largeur d'impulsion cadencé, au mode de commande linéaire, donnant un signal continu, mode dans lequel le générateur à modulation de largeur d'impulsion passe aussi en mode linéaire avec branchement en permanence en fonction de la valeur réelle (IST) et de la valeur de consigne (SOLL), et les étages de sortie de puissance (FET1, FET2, FETn) sont branchés en permanence et sont régulés de façon linéaire par le circuit de protection (LSR1, LSR2, LSR3).

2. Etage de sortie de puissance selon la revendication 1,
**caractérisé en ce que**
la capacité du condensateur de surcouplage (C1, C2, Cn) est un multiple (10 à 20 fois) de la capacité d'entrée de l'étage de sortie de puissance (FET1, FET2, FETn).

3. Etage de sortie de puissance selon la revendication 1 ou 2,
**caractérisé par**
un circuit pilote (TS) entre le générateur à modulation de largeur d'impulsion (PWM-G) et l'organe de découplage (EK1, EK2, EKn).

4. Etage de sortie de puissance selon l'une des revendications 1 à 3,
**caractérisé en ce que**
le générateur à modulation de largeur d'impulsion (PWM-G) commande directement ou par le circuit pilote (TS) plusieurs étages de sortie de puissance (FET1, FET2, FETn), découplés les uns par rapport aux autres par des organes de découplage individuels (EK1, EK2, EKn), étages de sortie de puissance auxquels sont associés les circuits de protection individuels (LSR1, LSR2, LSRn), et
les circuits de protection individuels (LSR1, LSR2, LSRn) émettent des signaux de commande linéaire individuels (u11, u12, uln) pour les étages de sortie de puissance (FET1. FET2, FETn).

5. Etage de sortie de puissance selon la revendication 4,
**caractérisé en ce que**
les sorties des étages de sortie de puissance (FET1, FET2, FETn) sont branchées en parallèle, et
tous les circuits de protection (LSR1, LSR2, LSRn) reçoivent la tension de sortie commune (Uaus) comme valeur réelle.

6. Etage de sortie de puissance selon la revendication 4 ou 5,
**caractérisé en ce que**
les étages de sortie de puissance (FET1, FET2, FETn) sont réalisés avec des transistors (FET).

7. Etage de sortie de puissance selon l'une des revendications 4 à 6,
**caractérisé en ce que**
les branchements de porte des étages de sortie de puissance (FET1, FET2, FETn) sont accessibles comme branchements de contrôle.
